# NEUE EUROPÄISCHE PATENTSCHRIFT

(11) **EP 2 686 462 B2**
(45) Veröffentlichungstag und Bekanntmachung des Hinweises auf die Entscheidung über den Einspruch: **10.08.2022**
(45) Hinweis auf die Patenterteilung: 31.12.2014
(21) Anmeldenummer: 12715313.8
(22) Anmeldetag: 15.03.2012
(51) Int. Cl.: C23C 16/34, C23C 16/36

(54) **BESCHICHTETER KÖRPER UND VERFAHREN ZU DESSEN HERSTELLUNG**
COATED BODY AND METHOD FOR THE PRODUCTION THEREOF
CORPS POURVU D'UN REVÊTEMENT ET SON PROCÉDÉ DE PRODUCTION

(30) Priorität: 18.03.2011 AT 3842011
(43) Veröffentlichungstag der Anmeldung: 22.01.2014
(73) Patentinhaber: Boehlerit GmbH & Co. KG., 8605 Kapfenberg (AT)
(72) Erfinder: PITONAK, Reinhard, A-8600 Bruck an der Mur (AT); WEIßENBACHER, Ronald, A-8600 Bruck an der Mur (AT); KÖPF, Arno, A-8605 Kapfenberg (AT)
(74) Vertreter: Wirnsberger, Gernot
(86) Internationale Anmeldenummer: PCT/AT2012/050035
(87) Internationale Veröffentlichungsnummer: WO 2012/126030

(56) Entgegenhaltungen:
- EP-A1- 0 653 499
- EP-A1- 0 709 484
- EP-A1- 1 803 835
- WO-A1-2007/003648
- WO-A1-2008/031768
- DE-A1-102008 013 964
- DE-A1-102008 013 965
- DE-A1-102008 013 966
- DE-A1-102008 013 966
- JP-A- 2005 297 143
- US-A1- 2009 130 434
- US-A1- 2011 003 126
- I. Endler et al, Surface & Coatings Technology 203, 2008, 530-533
- J.Keckes et al, Thin Solid Films 545, 2013 29-32
- Fertigungsverfahren Drehen, Frasen, Bohren, 8. Auflage VDI, Seiten 139-146

## Beschreibung

Die Erfindung betrifft ein Verfahren zur Herstellung eines beschichteten Körpers, wobei der Körper bereitgestellt und auf dem Körper eine mehrlagige Beschichtung abgeschieden wird, die zumindest eine mittels eines CVD-Verfahrens abgeschiedene Beschichtungslage mit AlₓTi₁₋ₓN aufweist.

Des Weiteren betrifft die Erfindung einen beschichteten Körper mit einer mehrlagigen Beschichtung, die zumindest eine Beschichtungslage mit AlₓTi₁₋ₓN aufweist, die mittels eines CVD-Verfahrens abgeschieden ist.

Aus dem Stand der Technik ist es bekannt, dass Schneidwerkzeuge oder Schneideinsätze zur Erhöhung einer Standzeit im Schneideinsatz mit Beschichtungslagen beschichtet werden, die aus Titan, Aluminium und Stickstoff zusammengesetzt sind. Allgemein wird diesbezüglich oftmals von TiAIN-Beschichtungslagen gesprochen, wobei eine durchschnittliche chemische Zusammensetzung, unabhängig davon, ob eine oder mehrere Phasen in der Beschichtungslage vorliegen, mit Ti₁₋ₓAlₓN angegeben wird. Für Beschichtungslagen, die mehr Aluminium als Titan enthalten, ist auch die Nomenklatur AlTiN bzw. genauer AlₓTi₁₋ₓN gebräuchlich.

Aus der WO 03/085152 A2 ist es bekannt, im System AlTiN monophasige Beschichtungslagen mit einer kubischen Struktur herzustellen, wobei bei einem relativen Anteil von Aluminiumnitrid (AIN) bis zu 67 Molprozent (Mol-%) eine kubische Struktur des AlTiN erhalten wird. Bei höheren AlN-Gehalten von bis zu 75 Mol-% entsteht ein Gemisch aus kubischem AlTiN und hexagonalem AIN und bei einem AIN-Gehalt von mehr als 75 Mol-% ausschließlich hexagonales AIN und kubisches Titannitrid (TiN). Gemäß der genannten Druckschrift werden die beschriebenen AlTiN-Beschichtungslagen mittels Physical Vapor Deposition (PVD) abgeschieden. Mit einem PVD-Verfahren sind somit maximale relative Anteile von AIN praktisch auf 67 Mol-% beschränkt, da sonst ein Umkippen in Phasen möglich ist, die Aluminium nur in Form von hexagonalem AIN enthalten. Ein höherer relativer Anteil von AIN in einer kubischen Phase ist jedoch erwünscht, um eine Verschleißbeständigkeit möglichst zu maximieren.

Aus dem Stand der Technik ist es auch bekannt, anstelle von PVD-Verfahren Chemical Vapor Deposition (CVD) einzusetzen, wobei ein CVD-Verfahren bei relativ niedrigen Temperaturen im Temperaturfenster von 700 °C bis 900 °C durchzuführen ist, da kubische AlTiN-Beschichtungslagen bei Temperaturen von z. B. ≥ 1000 °C aufgrund der metastabilen Struktur derartiger Beschichtungslagen nicht herstellbar sind. Gegebenenfalls können die Temperaturen gemäß der US 6,238,739 B1 auch noch tiefer liegen, und zwar im Temperaturfenster von 550 °C bis 650 °C, wobei allerdings hohe Chlorgehalte in der Beschichtungslage in Kauf zu nehmen sind, was sich für einen Anwendungsfall als nachteilig erweist. Man hat daher versucht, CVD-Verfahren so zu optimieren, dass mit diesen AlTiN-Beschichtungslagen mit einem hohen Anteil von Aluminium und kubischer Struktur der Beschichtungslage herstellbar sind (I. Endler et al., Proceedings Euro PM 2006, Ghent, Belgien, 23. bis 25. Oktober 2006, Vol. 1, 219). Wenngleich diese Beschichtungslagen eine hohe Mikrohärte und damit grundsätzlich günstige Eigenschaften für eine hohe Verschleißbeständigkeit im Einsatz aufweisen, so hat es sich doch erwiesen, dass eine Haftfestigkeit derartiger Beschichtungslagen zu gering sein kann. Diesbezüglich wurde daher in der DE 10 2007 000 512 B3 vorgeschlagen, unterhalb einer kubischen AlTiN-Beschichtungslage, die 3 µm dick ist, eine 1 µm dicke Beschichtungslage vorzusehen, die als Phasengradientenschicht ausgebildet ist und aus einem Phasengemisch aus hexagonalem AIN, TiN und kubischem AlTiN besteht, wobei ein kubischer AlTiN-Anteil mit nach außen hin bzw. zur (ausschließlich) kubischen AlTiN-Beschichtungslage einen steigenden Anteil aufweist. Entsprechend beschichtete Schneidplatten wurden zu einem Fräsen von Stahl eingesetzt, wobei allerdings gegenüber Beschichtungslagen, die mittels eines PVD-Verfahrens hergestellt wurden, lediglich geringe Verbesserungen einer Verschleißfestigkeit erzielt wurden.

Neben der nur geringen Verbesserung einer Verschleißfestigkeit besteht ein weiterer Nachteil einer Anbindungsschicht gemäß der DE 10 2007 000 512 B3 darin, dass die Anbindungs- bzw. Phasengradientenschicht äußerst schnell aufwächst, auch bei Versuchen im Labormaßstab (I. Endler et al., Proceedings Euro PM 2006, Ghent, Belgien, 23. bis 25. Oktober 2006, Vol. 1, 219). Dies führt bei einer Herstellung in einem größeren Reaktor, der für ein großtechnisches Beschichten von Schneidplatten ausgelegt ist, dazu, dass die Anbindungs- bzw. Phasengradientenschicht im vorgesehenen Beschichtungsprozess äußerst dick wird, da eine Temperatur zur Ausbildung der letztlich vorgesehenen kubischen AlTiN abzusenken ist, was entsprechende Zeit erfordert. Während dieser Absenkung einer Prozesstemperatur wächst jedoch eine Dicke der Anbindungs- bzw. Phasengradientenschicht rasch an, weil in einem großtechnischen Reaktor eine schnelle Abkühlung nicht möglich ist. Denkbar wäre es, den Beschichtungsprozess für längere Zeit bzw. das Abkühlen zu unterbrechen, was allerdings nicht wirtschaftlich ist.

DE 10 2008 013966 A1 offenbart einen Körper mit einer mehrlagigen Beschichtung, wobei eine Beschichtungslage AlₓTi₁₋ₓN auf einer Beschichtungslage aus TiCN ist.

Aufgabe der Erfindung ist es, ein Verfahren der eingangs genannten Art anzugeben, mit dem auf wirtschaftliche Weise eine hoch verschleißfeste Beschichtung aufbringbar ist.

Ein weiteres Ziel der Erfindung besteht darin, einen Körper der eingangs genannten Art anzugeben, der wirtschaftlich herstellbar ist und eine hohe Verschleißfestigkeit aufweist.

Die verfahrensmäßige Aufgabe wird erfindungsgemäß durch ein Verfahren gemäß Anspruch 1 gelöst.

Ein mit der Erfindung erzielter Vorteil ist darin zu sehen, dass ein Abscheiden einer Beschichtungslage aus TiCN mit länglichen Kristallen von TiCN in einem Temperaturfenster erfolgen kann, das bei einem großtechnischen Reaktor unter gleichzeitiger Abscheidung dieser Beschichtungslage eine Abkühlung auf eine erforderliche Temperatur für eine nachfolgende Abscheidung der Beschichtungslage mit AlₓTi₁₋ₓN ermöglicht, ohne dass die TiCN-Beschichtungslage allzu dick wird. Daneben hat sich gezeigt, dass die TiCN-Beschichtungslage nicht bloß nur eine günstige Anbindungsschicht ist, die eine gute Haftung der Beschichtungslage mit AlₓTi₁₋ₓN sicherstellt, sondern auch die Morphologie in der nachfolgend abgeschiedenen Beschichtungslage mit AlₓTi₁₋ₓN äußerst vorteilhaft beeinflusst, sodass eine haftfeste, hoch verschleißfeste Beschichtungslage mit AlₓTi₁₋ₓN erhalten wird. Insbesondere zeigt sich, dass die Beschichtungslage mit AlₓTi₁₋ₓN im Bereich einer Anbindung an die TiCN-Beschichtungslage mit einer lamellaren Struktur ausgebildet ist. Die Ursachen hierfür sind noch nicht bekannt, allerdings wird vermutet, dass ein epitaktisches Aufwachsen zumindest in den unmittelbar angrenzenden Bereichen der Beschichtungslagen erfolgt. Im weiteren Verlauf des Abscheidens der Beschichtungslage mit AlₓTi₁₋ₓN kann sich die Morphologie ändern. Insgesamt scheint die entsprechende Morphologie der Beschichtungslage mit AlₓTi₁₋ₓN für die hohe Verschleißfestigkeit verantwortlich zu sein, was durch Mikrohärtemessungen bestätigt wird, wonach die genannte Beschichtungslage eine Mikrohärte von zumindest 3100 HV_{0,01} aufweist.

Bevorzugt ist vorgesehen, dass die TiCN-Beschichtungslage bei einer Temperatur von 800 °C bis 880 °C abgeschieden wird. Grundsätzlich könnten für die Herstellung der TiCN-Beschichtungslage mit länglichen Kristallen auch tiefere Temperaturen gewählt werden, allerdings müsste dann anschließend wieder ein Erwärmen erfolgen, um die Beschichtungslage mit AlₓTi₁₋ₓN abzuscheiden.

Die TiCN-Beschichtungslage wird zweckmäßigerweise mit einer Dicke von bis zu 7 µm, vorzugsweise 2 bis 5 µm, abgeschieden. Eine entsprechende Dicke ist ausreichend, um der Beschichtung insgesamt eine erforderliche Zähigkeit zu verleihen bzw. allfällige Zug- und/oder Druckspannungen möglichst zu vermeiden. Eine gewisse Zähigkeit der Beschichtung insgesamt ist auch erforderlich, da die Beschichtungslage mit AlₓTi₁₋ₓN eine hohe Härte und daher eine eher geringe Zähigkeit aufweist.

Die Herstellung der TiCN-Beschichtungslage kann, wie an sich aus dem Stand der Technik bekannt, erfolgen. Diesbezüglich wird zweckmäßigerweise die TiCN-Beschichtungslage aus einem Gas enthaltend oder bestehend aus Stickstoff, Wasserstoff, Acetonitril und Titantetrachlorid abgeschieden. Um bei den vergleichsweise hohen Temperaturen der Abscheidung der TiCN-Beschichtungslage von 800 °C bis 880 °C eine Dicke dieser Beschichtungslage gezielt zu kontrollieren, kann im Gegensatz zum Stand der Technik das Gas mit einem höheren Stickstoffanteil als Wasserstoffanteil eingesetzt werden, wodurch eine Abscheidungsgeschwindigkeit gering gehalten werden kann. Zweckmäßig ist es diesbezüglich, dass der Stickstoffanteil zumindest das Zweifache, bevorzugt zumindest das Vierfache, insbesondere das Sechsfache, des Wasserstoffgehaltes beträgt. Die Beschichtungslage mit AlₓTi₁₋ₓN wird bevorzugt bei einer Temperatur gleich oder unterhalb einer Temperatur einer Abscheidung der TiCN-Beschichtungslage abgeschieden. Damit kann ein Prozess zur Herstellung einer Beschichtung in Bezug auf eine Temperaturführung effizient gestaltet werden. Es ist dann möglich, ausgehend von einer Ausgangstemperatur, die Temperatur während einer Herstellung der Beschichtungslage kontinuierlich zu senken, wobei eine vorteilhafte Beschichtung in kurzer Zeit erhalten werden kann.

Bevorzugt wird die Beschichtungslage mit AlₓTi₁₋ₓN bei einer Temperatur von 800 °C bis 830 °C abgeschieden.

Um eine günstige Ausbildung der Beschichtungslage mit AlₓTi₁₋ₓN zu erhalten, wird diese aus einem ersten Gemisch von Stickstoff, Wasserstoff und Titantetrachlorid und einem zweiten Gemisch von Stickstoff und NH₃ abgeschieden, wobei eine Abscheidung bei einem Druck von 20 bis 40 mbar erfolgen kann. Die Beschichtungslage mit AlₓTi₁₋ₓN wird dabei bevorzugt mit einer Dicke von 3 bis 10 µm abgeschieden. Durch die entsprechenden Verfahrensparameter lässt sich eine Beschichtungslage mit AlₓTi₁₋ₓN abscheiden, die im Vergleich zu Titan einen Aluminiumgehalt von mehr als 90 Mol-% aufweist und überwiegend mit einer kubischen Struktur ausgebildet ist, wobei in der Regel ein Anteil von hexagonalem AIN im Ausmaß von bis zu 30 Mol-% sowie geringere Gehalte von bis zu 8 Mol-% TiN vorliegen.

Ein erfindungsgemäßes Verfahren kann zum Beschichten beliebiger Körper Anwendung finden, wird bevorzugt jedoch dann eingesetzt, wenn ein Körper aus einem Hartmetall zu beschichten ist. Als Hartmetall kommen übliche Varianten von Carbiden und/oder Carbonitriden und/oder Nitriden von Metallen wie Wolfram, Titan, Tantal, Vanadium und/oder Niob zur Anwendung, die durch ein Bindemetall wie Cobalt und/oder Nickel und/oder Eisen gebunden sind. Üblicherweise besteht das Hartmetall aus Partikeln von Wolframcarbid, gegebenenfalls mit geringeren Anteilen von Carbiden, Carbonitriden und/oder Nitriden von Titan, wobei ein Bindemetallanteil bis zu 20 Gewichtsprozent (Gew.-%), vorzugsweise bis zu 12 Gew.-%, beträgt. Wird als Körper ein Körper aus Hartmetall eingesetzt, so ist es zweckmäßig, unmittelbar auf diesem eine Anbindungsschicht aus TiN abzuscheiden, und zwar vorzugsweise mit einer Dicke von weniger als 1,0 µm. Eine derartige Anbindungsschicht erlaubt unter Minimierung von Zug- und/oder Druckspannungen eine Abscheidung weiterer Schichten, wobei beispielsweise bei Cobalt als Bindemetall in die abgeschiedene TiN-Anbindungsschicht diffundiert, was zu einer hohen Haftfestigkeit der Beschichtung insgesamt führt. Auf der Anbindungsschicht kann die TiCN-Beschichtungslage abgeschieden werden.

Im Rahmen eines erfindungsgemäßen Verfahrens wird, einer effizienten bzw. wirtschaftlichen Verfahrensführung wegen, zumindest eine Beschichtungslage, vorzugsweise alle, mittels eines CVD-Verfahrens abgeschieden. Diesbezüglich erweist es sich als besonders zweckmäßig, wenn bei der Abscheidung der Anbindungsschicht und nachfolgenden Abscheidung jeder Beschichtungslage jeweils eine Abscheidungstemperatur abgesenkt oder gehalten wird.

Das weitere Ziel der Erfindung wird durch einen beschichten Körper gemäß Anspruch 15 erreicht.

Vorteile eines erfindungsgemäßen Körpers liegen insbesondere darin, dass bei diesem die Beschichtung nicht nur haftfest, sondern auch hoch verschleißfest ist. Dies führt dazu, dass ein entsprechender Körper, der beispielsweise als Schneidwerkzeug oder Schneideinsatz hierfür ausgebildet sein kann, im Einsatz äußert verschleißfest ist, insbesondere auch bei hohen Temperaturen, wie diese beispielsweise bei einem Fräsen von metallischen Werkstoffen, insbesondere Stählen oder Gusswerkstoffen, die mehr als 2 Gew.-% Kohlenstoff in Form von Graphit enthalten, auftreten. Darüber hinaus kann die Beschichtung in wirtschaftlicher Weise abgeschieden werden.

Die TiCN-Beschichtungslage weist dabei im Querschnitt längserstreckte Kristalle auf, die vorzugsweise überwiegend in einem Winkel von ±30° zu einer Oberflächennormalen des Körpers verlaufen. Bei einer entsprechenden TiCN-Beschichtungslage ergibt sich eine gute Anbindung der nachfolgend abgeschiedenen Beschichtungslage mit AlₓTi₁₋ₓN. Diesbezüglich ist es zweckmäßig, dass die TiCN-Beschichtungslage eine durchschnittliche Zusammensetzung TiCₐN₁₋ₐ mit a im Bereich von 0,3 bis 0,8, insbesondere 0,4 bis 0,6, aufweist.

Hinsichtlich der Beschichtungslage mit bzw. aus AlₓTi₁₋ₓN ist es vorteilhaft, dass diese eine durchschnittliche Zusammensetzung AlₓTi₁₋ₓN aufweist, wobei x ≥ 0,7 ist und hexagonales AIN in einem Anteil von mehr als 0 bis zu 30 Mol-% vorliegt. Eine derartige Ausbildung der Beschichtungslage mit bzw. aus AlₓTi₁₋ₓN hat sich als besonders günstig erwiesen. Im Unterschied zum Stand der Technik zeigt sich ein bestimmter, eingeschränkter Anteil von hexagonalem AIN als günstig in Bezug auf eine Verschleißfestigkeit der Beschichtung insgesamt. Vermutet wird, dass durch geringe Anteile von hexagonalem AIN eine Zähigkeit der an sich besonders harten Beschichtungslage mit vornehmlich kubischem AlₓTi₁₋ₓN erzielt wird, sodass diese Beschichtungslage neben hoher Haftfestigkeit und Härte auch eine ausreichende Zähigkeit aufweist, um hohen Beanspruchungen möglichst lange standhalten zu können. Die Beschichtungslage mit bzw. aus AlₓTi₁₋ₓN kann eine äußerste Beschichtungslage und/oder mit einer Dicke von 4 bis 10 µm ausgebildet sein. In diesem Zusammenhang kann vorgesehen sein, dass x ≥ 0,75, vorzugsweise ≥ 0,80, insbesondere ≥ 0,85, ist. Ein Anteil an hexagonalem AIN beträgt diesbezüglich vorzugsweise mehr als 12,5 Mol-%, vorzugsweise mehr als 15,0 Mol-%, insbesondere mehr als 20,0 Mol-%.

Ein Anteil an kubischer AlₓTi₁₋ₓN-Phase in der Beschichtungslage mit bzw. aus AlₓTi₁₋ₓN beträgt zumindest 70 Mol-%, bevorzugt 70 bis 80 Mol-%. Die übrigen Anteile werden von hexagonalem AIN sowie kubischem TiN gebildet.

Vorgesehen ist, dass die Beschichtungslage mit bzw. aus AlₓTi₁₋ₓN ganz oder zumindest teilweise Kristalle mit einer lamellaren Struktur aufweist, insbesondere in einem Bereich der Anbindung an die TiCN-Beschichtungslage. Dabei kann eine lamellare Struktur der Kristalle Lamellen mit einer Dicke von weniger als 100 nm, vorzugsweise weniger als 50 nm, insbesondere weniger als 25 nm, aufweisen.

Wenn der Körper aus einem Hartmetall gebildet ist, ist am Körper bevorzugt eine Anbindungsschicht aus TiN, vorzugsweise mit einer Dicke von weniger als 1,0 µm, abgeschieden, um eine gute Anbindung der Beschichtung insgesamt am Hartmetallkörper zu erreichen. Die TiCN-Beschichtungslage ist dann bevorzugt unmittelbar auf der Anbindungsschicht abgeschieden.

Für eine effektive bzw. wirtschaftliche Verfahrensführung ist es zweckmäßig, dass alle Beschichtungslagen mittels CVD-Verfahren abgeschieden sind.

Weitere Merkmale, Vorteile und Wirkungen der Erfindung ergeben sich anhand des nachfolgend dargestellten Ausführungsbeispiels. In den Zeichnungen, auf welche dabei Bezug genommen wird, zeigen:
Fig. 1 eine schematische Darstellung eines beschichteten Schneideinsatzes;
Fig. 2 eine transmissionselektronenmikroskopische Aufnahme eines Teils eines beschichteten Schneideinsatzes;
Fig. 3 eine transmissionselektronenmikroskopische Aufnahme einer AITiN-Beschichtungslage;
Fig. 4a eine freie Fläche eines Schneideinsatzes nach einer vorgegebenen Einsatzzeit;
Fig. 4b eine freie Fläche eines Schneideinsatzes nach einer vorgegebenen Einsatzzeit;
Fig. 5a eine Spanfläche eines Schneideinsatzes nach einer vorgegebenen Einsatzzeit;
Fig. 5b eine Spanfläche eines Schneideinsatzes nach einer vorgegebenen Einsatzzeit.

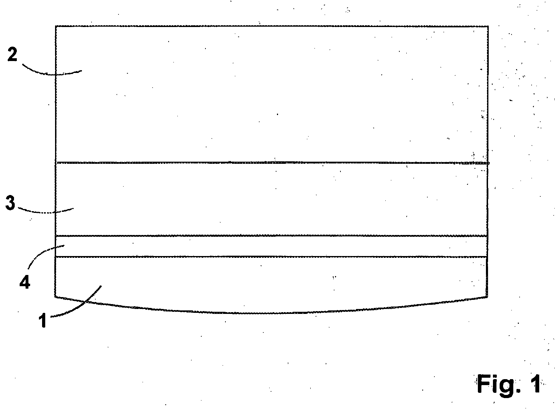

In Fig. 1 ist ein Körper 1 schematisch dargestellt, der eine mehrlagige Beschichtung aufweist. Die Beschichtung ist auf dem Körper 1 aufgebracht, wobei alle Schichten jeweils mittels eines CVD-Verfahrens erstellt sind. Der Körper 1 kann aus einem beliebigen Material bestehen, besteht üblicherweise jedoch aus einem Hartmetall, das aus Carbiden und/oder Carbonitriden von Wolfram, Titan, Niob oder anderen Metallen und einem Bindemetall ausgewählt aus der Gruppe Cobalt, Nickel und Eisen besteht. Ein Bindemetallanteil beträgt dabei in der Regel bis zu 10 Gew.-%. Typischerweise besteht der Körper 1 aus bis zu 10 Gew.-% Cobalt und/oder anderen Bindemetallen, Rest Wolframcarbid und bis zu 5 Gew.-% weitere Carbide und/oder Carbonitride anderer Metalle. Auf dem Körper 1 ist eine Anbindungsschicht 4 aus TiN abgeschieden, die in der Regel eine maximale Dicke von 1,0 µm aufweist. Auf der Anbindungsschicht 4 ist eine beispielsweise 2 bis 5 µm dicke Schicht aus TiCN als Zwischenschicht abgeschieden, wobei es sich um eine Mitteltemperatur-TiCN-(MT-TiCN-)Beschichtungslage handelt. Eine derartige Beschichtungslage weist in der Regel eine kolumnare Struktur mit stängeligen Kristallen auf, die im Wesentlichen parallel zur Oberflächennormalen auf den Körper 1 ausgerichtet sind. Auf dieser Zwischenschicht bzw. MT-TiCN-Beschichtungslage 3 ist schließlich eine Beschichtungslage 2 mit AlₓTi₁₋ₓN abgeschieden, die eine durchschnittliche Summenformel AlₓTi₁₋ₓN aufweist, wobei x ≥ 0,7 ist. Diese Beschichtungslage 2 mit bzw. aus AlₓTi₁₋ₓN weist zu mehr als 70 Mol-% kubisches AlTiN auf und bzw. aus besteht im Übrigen aus 15 bis 25 Mol-% hexagonalem AIN. Der Rest besteht aus TiN.

Eine Beschichtung wie in Fig. 1 dargestellt kann auf einem Schneideinsatz, insbesondere einer Schneidplatte, abgeschieden werden, indem der Körper 1 bereitgestellt wird, wonach in einem ersten Schritt die Anbindungsschicht 4 aus TiN bei einer Prozesstemperatur von 870 °C bis 880 °C aus einem Gas enthaltend Stickstoff, Wasserstoff und Titantetrachlorid abgeschieden wird. Anschließend wird die Temperatur abgesenkt und bei einer Temperatur von 830 °C bis 870 °C die Zwischenschicht 3 bzw. eine MT-TiCN-Beschichtungslage mit einer Dicke von 2 bis 5 µm, abgeschieden. Die Abscheidung erfolgt dabei aus einem Gas bestehend aus Stickstoff, Wasserstoff, Acetonitril und Titantetrachlorid. Die entsprechende Verfahrenstemperatur und der Einsatz von Acetonitril als Kohlenstoff- bzw. Stickstoffquelle stellt eine Ausbildung der Zwischenschicht mit kolumnaren Wachstum bzw. stängeligen Kristallen aus TiCN sicher, die sich im Wesentlichen parallel zur Oberflächennormalen auf den Körper 1 erstrecken. Auf dieser Zwischenschicht, bei der Titan bis zu 40 Mol-% durch Aluminium ersetzt sein kann, um eine Härte zu steigern, wird schließlich die Beschichtungslage 2 mit AlₓTi₁₋ₓN aufgebracht, wofür die Temperatur auf etwa 800 °C bis 825 °C gesenkt wird. Die äußerste Beschichtungslage 2 wird aus einem Gas enthaltend Aluminiumtrichlorid, Stickstoff, Wasserstoff, Titantetrachlorid und einem gesondert zugeführten Gemisch von Ammoniak und Stickstoff erstellt. Somit kann in einem zweiten Schritt zur Herstellung der Zwischenschicht und in einem dritten Schritt zur Herstellung der äußersten Beschichtungslage 2 mit AlₓTi₁₋ₓN jeweils eine Prozesstemperatur gesenkt werden, was äußerst wirtschaftlich ist und eine rasche Erstellung der Beschichtung am Schneideinsatz erlaubt.

In den nachfolgenden Tabellen sind typische Prozessparameter bei der Herstellung einer Beschichtung und Eigenschaften einzelner Beschichtungslagen dargestellt.

**Tabelle 1 - Prozessparameter**

| | Temperatur (°C) | Gaszusammensetzung/Gasfluss (l/min) bzw. TiCl₄ und CH₃CN (ml/min) |
|---|---|---|
| Beschichtungslage | | |
| TiN | 880 - 900 | TiCl₄/2,7, N₂/14, H₂/17 |
| MT-TiCN | 750 - 850 | CH₃CN/0,5, TiCl₄/2,7, N₂/19, H₂/3 |
| AlTiN | 750 - 850 | HCl-AlCl₃/2,7-0,9, TiCl₄/0,3, NH₃-N₂/0,9-4,5, H₂/64 |

**Tabelle 2 - Eigenschaften der Beschichtungslagen**

| Beschichtungslage | Schichtdicke (µm) | | Zusammensetzung |
|---|---|---|---|
| | allgemein | bevorzugt | |
| TiN | ≤ 2 | 0,25 - 0,75 | TiN |
| MT-TiCN | 1 - 10 | 2 - 5 | TiCₐN₁₋ₐ, a = 0, 4 - 0,6 |
| AlTiN | 1 - 10 | 3 - 8 | AlₓTi₁₋ₓN, x = 0,85 - 0,98 |

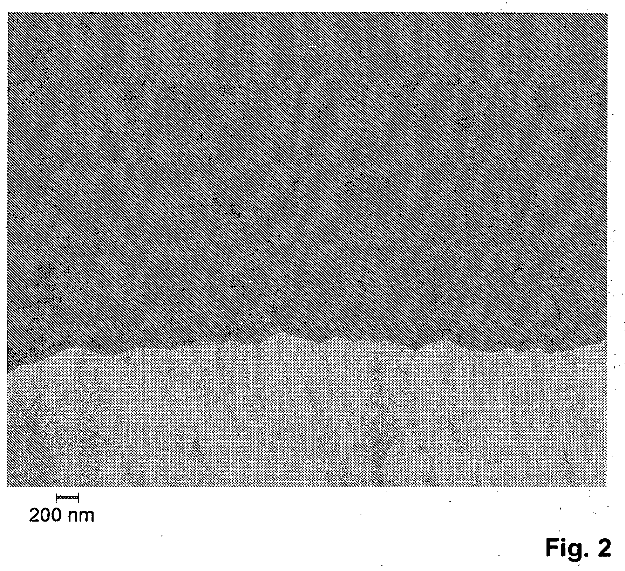

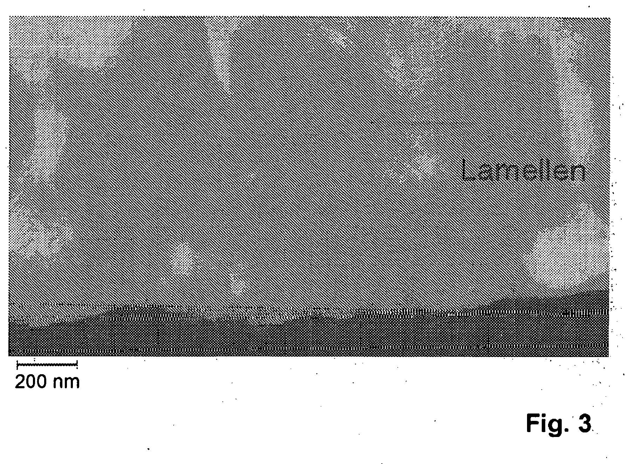

Die äußerste Beschichtungslage 2 weist bei Betrachtung in einem Transmissionselektronenmikroskop zumindest in einem an die Zwischenschicht 3 anschließenden Bereich ein kolumnares Wachstum auf, wobei, wie aus Fig. 2 und 3 ersichtlich ist, sehr feine Lamellen vorliegen, die eine Lamellendicke von weniger als 25 nm aufweisen. Vermutet wird, dass die äußerste Beschichtungslage 2 auf der im Ausführungsbeispiel vorgesehenen Zwischenschicht 3 epitaktisch aufwächst. Schneideinsätze eines bestimmten Typs wurden wie vorstehend beschrieben beschichtet. Zum Vergleich wurde eine Vielzahl von strukturell analogen Schneidwerkzeugen mit alternativen Beschichtungen versehen, vornehmlich mit AlTiN-Beschichtungen samt Anbindungsschichten, wobei jeweils ein PVD-Verfahren zum Einsatz kam. Die so hergestellten Schneideinsätze wurden anschließend in Bezug auf eine Standzeit bei einer trockenen Bearbeitung von Stählen und Gusswerkstoffen getestet, wobei unter anderem ein Edelstahl für Kunststoffformen bearbeitet wurde. Die Schnittdaten waren wie folgt:
v_{c} = 325 m/min
n = 1653 U/min
aₚ= 3 mm
aₑ = 32 mm
f_{z} = 0,30 mm/Z
V_{f} = 496 mm/min
κ = 45°
D = 52
Z = 1

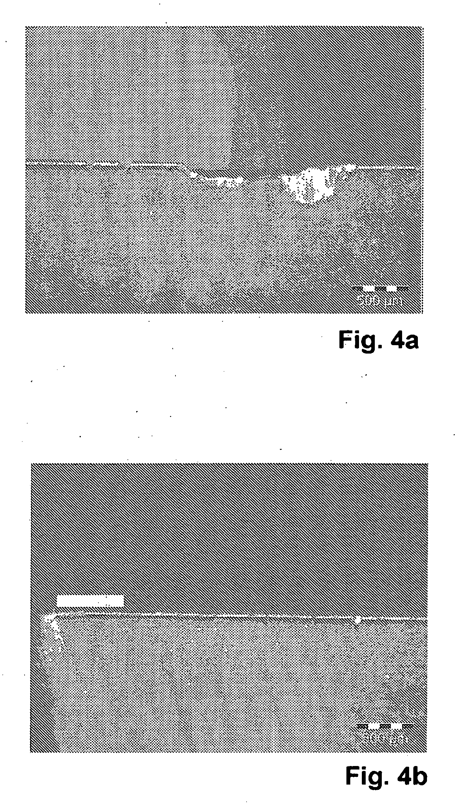

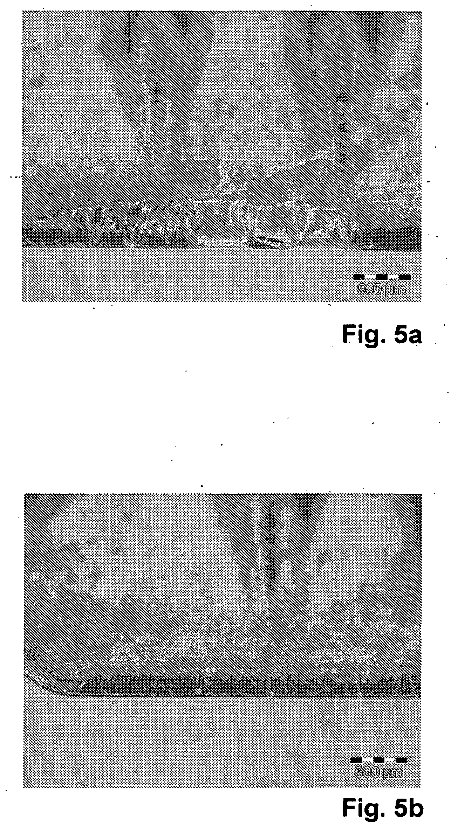

Wie erwähnt wurde eine Vielzahl von Beschichtungen getestet. In Fig. 4a und 5a sind Fotografien der besten Schneidplatte mit einer mittels eines PVD-Verfahrens erstellten AlTiN-Beschichtungslage nach einer Einsatzzeit von 28 Minuten dargestellt. Wie aufgrund der Ausbrüche an der Freifläche (Fig. 4a) und der Spanfläche (Fig. 5a) klar ersichtlich ist, ist nach dieser Zeit ein Standzeitende gegeben. Im Gegensatz dazu ist bei analogen Schneideinsätzen, die wie zuvor dargelegt mittels eines CVD-Verfahrens mit der angegebenen Schichtfolge beschichtet waren, nach derselben Zeit lediglich ein minimaler Verschleiß erkennbar, und zwar sowohl an der Freifläche (Fig. 4b) als auch der Spanfläche (Fig. 5b). Ein Ende der Standzeit bzw. deutliche Verschleißerscheinungen konnten erst nach 49 Minuten festgestellt werden, was einer Standzeitverlängerung von 75 % entspricht.

In weiteren Versuchen konnten Standzeiterhöhungen bei Gusseisenwerkstoffen mit Zugfestigkeiten von mehr als 1000 N/mm² von bis zu 200 % im Vergleich mit Beschichtungen auf Basis von mit einem PVD-Verfahren erstellten äußersten AlTiN-Beschichtungslagen festgestellt werden.

## Patentansprüche

1. Verfahren zur Herstellung eines beschichteten Körpers (1), wobei der Körper (1) bereitgestellt und auf dem Körper (1) eine mehrlagige Beschichtung abgeschieden wird, die zumindest eine mittels eines CVD-Verfahrens abgeschiedene Beschichtungslage (2) mit AlₓTi₁₋ₓN aufweist, **dadurch gekennzeichnet, dass** die Beschichtungslage(2) mit AlₓTi₁₋ₓN auf einer TiCN-Beschichtungslage (3) mit länglichen Kristallen von TiCN abgeschieden wird, bei der Titan optional bis zu 40 Mol-% durch Aluminium ersetzt sein kann, wobei die Beschichtungslage (2) mit AlₓTi₁₋ₓN ganz öder zumindest teilweise Kristalle mit einer lamellaren Struktur aufweist.

2. Verfahren nach Anspruch 1, **dadurch gekennzeichnet, dass** die TiCN-Beschichtungslage (3) bei einer Temperatur von 800 °C bis 880 °C abgeschieden wird.

3. Verfahren nach Anspruch 1 oder 2, **dadurch gekennzeichnet, dass** die TiCN-Beschichtungslage (3) mit einer Dicke von bis zu 7 µm, vorzugsweise 2 bis 5 µm, abgeschieden wird.

4. Verfahren nach einem der Ansprüche 1 bis 3, **dadurch gekennzeichnet, dass** die TiCN-Beschichtungslage (3) aus einem Gas enthaltend oder bestehend aus Stickstoff, Wasserstoff, Acetonitril und Titantetrachlorid abgeschieden wird.

5. Verfahren nach Anspruch 4, **dadurch gekennzeichnet, dass** das Gas mit Stickstoff und Wasserstoff als Trägergas eingesetzt wird.

6. Verfahren nach Anspruch 4 oder 5, **dadurch gekennzeichnet, dass** das Gas mit einem höheren Stickstoffanteil als Wasserstoffanteil eingesetzt wird.

7. Verfahren nach einem der Ansprüche 1 bis 6, **dadurch gekennzeichnet, dass** die Beschichtungslage (2) mit AlₓTi₁₋ₓN bei einer Temperatur gleich oder unterhalb einer Temperatur einer Abscheidung der TiCN-Beschichtungslage (3) abgeschieden wird.

8. Verfahren nach einem der Ansprüche 1 bis 7, **dadurch gekennzeichnet, dass** die Beschichtungslage (2) mit AlₓTi₁₋ₓN bei einer Temperatur von 800 °C bis 830 °C abgeschieden wird.

9. Verfahren nach einem der Ansprüche 1 bis 8, **dadurch gekennzeichnet, dass** die Beschichtungslage (2) mit AlₓTi₁₋ₓN aus einem ersten Gemisch von Stickstoff, Wasserstoff und Titantetrachlorid und einem zweiten Gemisch von Aluminiumtrichlorid, Stickstoff und NH₃ abgeschieden wird.

10. Verfahren nach einem der Ansprüche 1 bis 9, **dadurch gekennzeichnet, dass** die Beschichtungslage (2) mit AlₓTi₁₋ₓN bei einem Druck von 20 bis 40 mbar abgeschieden wird.

11. Verfahren nach einem der Ansprüche 1 bis 10, **dadurch gekennzeichnet, dass** die Beschichtungslage (2) mit AlₓTi₁₋ₓN mit einer Dicke von 3 bis 10 µm abgeschieden wird.

12. Verfahren nach einem der Ansprüche 1 bis 11, **dadurch gekennzeichnet, dass** ein Körper (1) aus einem Hartmetall eingesetzt wird, auf dem die mehrlagige Beschichtung abgeschieden wird.

13. Verfahren nach einem der Ansprüche 1 bis 12, **dadurch gekennzeichnet, dass** zumindest eine Beschichtungslage, vorzugsweise alle, mittels eines CVD-Verfahrens abgeschieden werden.

14. Verfahren nach Anspruch 13, **dadurch gekennzeichnet, dass** bei der Abscheidung der Anbindungsschicht (4) und nachfolgenden Abscheidung jeder Beschichtungslage (2, 3) jeweils eine Abscheidungstemperatur abgesenkt oder gehalten wird.

15. Beschichteter Körper (1) mit einer mehrlagigen Beschichtung, die zumindest eine mittels eines CVD-Verfahrens abgeschiedene Beschichtungslage (2) aus AlₓTi₁₋ₓN aufweist, **dadurch gekennzeichnet, dass** die Beschichtungslage (2) aus AlₓTi₁₋ₓN auf einer TiCN-Beschichtungslage (3) mit länglichen Kristallen von TiCN abgeschieden ist, bei der Titan optional bis zu 40 Mol-% durch Aluminium ersetzt sein kann, wobei die Beschichtungslage (2) aus AlₓTi₁₋ₓN ganz oder zumindest teilweise Kristalle mit einer lamellaren Struktur aufweist.

16. Beschichteter Körper (1) nach Anspruch 15, **dadurch gekennzeichnet, dass** die TiCN-Beschichtungslage (3) eine durchschnittliche Zusammensetzung TiCₐN₁₋ₐ mit a im Bereich von 0,3 bis 0,8, insbesondere 0,4 bis 0,6, aufweist.

17. Beschichteter Körper (1) nach Anspruch 15 oder 16, **dadurch gekennzeichnet, dass** die Beschichtungslage (2) mit AlₓTi₁₋ₓN eine durchschnittliche Zusammensetzung AlₓTi₁₋ₓN aufweist, wobei x ≥ 0,7 ist und hexagonales AIN in einem Anteil von mehr als 0 bis zu 30 Mol-% vorliegt.

18. Beschichteter Körper (1) nach Anspruch 17, **dadurch gekennzeichnet, dass** die Beschichtungslage (2) mit AlₓTi₁₋ₓN eine äußerste Beschichtungslage ist.

19. Beschichteter Körper (1) nach einem der Ansprüche 15 bis 18, **dadurch gekennzeichnet, dass** x ≥ 0,75, vorzugsweise x ≥ 0,80, insbesondere x ≥ 0;85, ist, wobei bevorzugt ein Anteil an hexagonalem AlN mehr als 12,5 Mol-%, vorzugsweise mehr als 15,0 Mol-%, insbesondere mehr als 20,0 Mοl-%, beträgt und wobei bevorzugt ein Anteil an kubischer AlₓTi₁₋ₓN-Phase in der Beschichtungslage (2) mit AlₓTi₁₋ₓN zumindest 70 Mol-%, vorzugsweise 70 bis 80 Mol-% beträgt.

20. Beschichteter Körper (1) nach Anspruch 15, **dadurch gekennzeichnet, dass** die lamellare Struktur der Kristalle Lamellen mit einer Dicke von weniger als 100 nm, vorzugsweise weniger als 50 nm, insbesondere weniger als 25 nm, aufweist.

## Claims

1. A process for the production of a coated body (1), wherein the body (1) is provided and a multi-layer coating which comprises at least one coating layer (2) containing AlₓTi₁₋ₓN is deposited on the body (1) by means of a CVD process, **characterized in that** the coating layer (2) containing AlₓTi₁₋ₓN is deposited on a TiCN coating layer (3) containing elongated crystals of TiCN, wherein up to 40 mole % of the titanium can optionally be replaced by aluminium, wherein the coating layer (2) containing AlₓTi₁₋ₓN completely or at least partially comprises crystals with a lamellar structure.

2. The process according to claim 1, **characterized in that** the TiCN coating layer (3) is deposited at a temperature of 800°C to 880°C.

3. The process according to claim 1 or 2, **characterized in that** the TiCN coating layer (3) is deposited with a thickness of up to 7 µm, preferably 2 to 5 µm.

4. The process according to one of claims 1 to 3, **characterized in that** the TiCN coating layer (3) is deposited from a gas containing or consisting of nitrogen, hydrogen, acetonitrile and titanium tetrachloride.

5. The process according to claim 4, **characterized in that** the gas is used with nitrogen and hydrogen as the carrier gas.

6. The process according to claim 4 or 5, **characterized in that** the gas is used with a higher proportion of nitrogen than hydrogen.

7. The process according to one of claims 1 to 6, **characterized in that** the coating layer (2) containing AlₓTi₁₋ₓN is deposited at a temperature which is less than or equal to a temperature for depositing the TiCN coating layer (3).

8. The process according to one of claims 1 to 7, **characterized in that** the coating layer (2) containing AlₓTi₁₋ₓN is deposited at a temperature of 800°C to 830°C.

9. The process according to one of claims 1 to 8, **characterized in that** the coating layer (2) containing AlₓTi₁₋ₓN is deposited from a first mixture of nitrogen, hydrogen and titanium tetrachloride and a second mixture of aluminium trichloride, nitrogen and NH₃.

10. The process according to one of claims 1 to 9, **characterized in that** the coating layer (2) containing AlₓTi₁₋ₓN is deposited at a pressure of 20 to 40 mbar.

11. The process according to one of claims 1 to 10, **characterized in that** the coating layer (2) containing AlₓTi₁₋ₓN is deposited with a thickness of 3 to 10 µm.

12. The process according to one of claims 1 to 11, **characterized in that** a body (1) formed from a hard alloy is used, onto which the multi-layer coating is deposited.

13. The process according to one of claims 1 to 12, **characterized in that** at least one coating layer, preferably all, is deposited by means of a CVD process.

14. The process according to claim 13, **characterized in that** during deposition of the binding layer (4) and subsequent deposition of each coating layer (2, 3), a respective temperature of deposition is reduced or maintained.

15. A coated body (1) with a multi-layer coating which comprises at least one coating layer (2) produced from AlₓTi₁₋ₓN deposited by means of a CVD process, **characterized in that** the coating layer (2) produced from AlₓTi₁₋ₓN is deposited on a TiCN coating layer (3) containing elongated crystals of TiCN, wherein up to 40 mole % of the titanium can optionally be replaced by aluminium, wherein the coating layer (2) produced from AlₓTi₁₋ₓN completely or at least partially comprises crystals with a lamellar structure.

16. The coated body (1) according to claim 15, **characterized in that** the TiCN coating layer (3) has a mean composition TiCₐN₁₋ₐ, where a is in the range 0.3 to 0.8, in particular 0.4 to 0.6.

17. The coated body (1) according to claim 15 or claim 16, **characterized in that** the coating layer (2) containing AlₓTi₁₋ₓN has a mean composition AlₓTi₁₋ₓN, wherein x ≥ 0.7 and hexagonal AlN is present in a proportion of more than 0 up to 30 mole %.

18. The coated body (1) according to claim 17, **characterized in that** the coating layer (2) containing AlₓTi₁₋ₓN is an outermost layer of coating.

19. The coated body (1) according to one of claims 15 to 18, **characterized in that** x ≥ 0.75, preferably x ≥ 0.80, in particular x ≥ 0.85, wherein preferably, a proportion of hexagonal AlN is more than 12.5 mole %, preferably more than 15.0 mole %, in particular more than 20.0 mole %, and wherein preferably, a proportion of cubic AlₓTi₁₋ₓN phase in the coating layer (2) containing AlₓTi₁₋ₓN is at least 70 mole %, preferably 70 to 80 mole %.

20. The coated body (1) according to claim 15, **characterized in that** the lamellar structure of the crystals comprises lamellae with a thickness of less than 100 nm, preferably less than 50 nm, in particular less than 25 nm.

## Revendications

1. Procédé de fabrication d'un corps (1) revêtu, consistant à fournir le corps (1) et à déposer sur le corps (1) un revêtement multicouche comportant au moins une couche de revêtement (2) qui renferme du AlₓTi₁₋ₓN et qui a été déposée au moyen d'un procédé de type CVD, **caractérisé en ce que** la couche de revêtement (2) qui renferme du AlₓTi₁₋ₓN est déposée sur une couche de revêtement en TiCN (3) laquelle renferme des cristaux de TiCN oblongs et dans laquelle on peut optionnellement remplacer jusqu'à 40 % en moles de titane par l'aluminium, la couche de revêtement (2) qui renferme du AlₓTi₁₋ₓN comportant au moins partiellement ou bien dans son intégralité des cristaux ayant une structure lamellaire.

2. Procédé selon la revendication 1, **caractérisé en ce que** la couche de revêtement en TiCN (3) est déposée à une température comprise entre 800 °C et 880 °C.

3. Procédé selon les revendications 1 ou 2, **caractérisé en ce que** la couche de revêtement en TiCN (3) est déposée de manière à obtenir une épaisseur jusqu'à 7 µm, préférentiellement comprise entre 2 et 5 µm.

4. Procédé selon l'une des revendications 1 à 3, **caractérisé en ce que** la couche de revêtement en TiCN (3) est déposée à partir d'un gaz lequel contient de l'azote, de l'hydrogène, de l'acétonitrile et du tétrachlorure de titane, ou lequel en est constitué.

5. Procédé selon la revendication 4, **caractérisé en ce que** ledit gaz renfermant de l'azote et de l'hydrogène est mis en œuvre comme gaz vecteur.

6. Procédé selon les revendications 4 ou 5, **caractérisé en ce que** ledit gaz est mis en œuvre à manière à ce que sa proportion d'azote soit plus élevée que sa proportion d'hydrogène.

7. Procédé selon l'une des revendications 1 à 6, **caractérisé en ce que** la couche de revêtement (2) qui renferme du AlₓTi₁₋ₓN est déposée à une température inférieure ou égale à une température à laquelle la couche de revêtement en TiCN (3) est déposée.

8. Procédé selon l'une des revendications 1 à 7, **caractérisé en ce que** la couche de revêtement (2) qui renferme du AlₓTi₁₋ₓN est déposée à une température comprise entre 800 °C et 830 °C.

9. Procédé selon l'une des revendications 1 à 8, **caractérisé en ce que** la couche de revêtement (2) qui renferme du AlₓTi₁₋ₓN est déposée à partir d'un premier mélange d'azote, d'hydrogène et de tétrachlorure de titane et à partir d'un deuxième mélange de trichlorure d'aluminium, d'azote et de NH₃.

10. Procédé selon l'une des revendications 1 à 9, **caractérisé en ce que** la couche de revêtement (2) qui renferme du AlₓTi₁₋ₓN est déposée en mettant en œuvre une pression comprise entre 20 et 40 mbar.

11. Procédé selon l'une des revendications 1 à 10, **caractérisé en ce que** la couche de revêtement (2) qui renferme du AlₓTi₁₋ₓN est déposée de manière à obtenir une épaisseur comprise entre 3 et 10 µm.

12. Procédé selon l'une des revendications 1 à 11, **caractérisé en ce que** l'on met en œuvre un corps (1) lequel est constitué d'un métal dur et sur lequel on dépose ledit revêtement multicouche.

13. Procédé selon l'une des revendications 1 à 12, **caractérisé en ce que** l'on dépose au moins une couche de revêtement, de préférence toutes, au moyen d'un procédé CVD.

14. Procédé selon la revendication 13, **caractérisé en ce que**, lors du dépôt de la couche de liaison (4) et lors du dépôt ultérieure de chacune des couches de revêtement (2, 3), la température de dépôt concernée est abaissée ou maintenue.

15. Corps (1) revêtu comportant un revêtement multicouche comportant au moins une couche de revêtement (2) qui renferme du AlₓTi₁₋ₓN et qui a été déposée au moyen d'un procédé de type CVD, **caractérisé en ce que** la couche de revêtement (2) qui renferme du AlₓTi₁₋ₓN est déposée sur une couche de revêtement en TiCN (3) laquelle renferme des cristaux de TiCN oblongs et dans laquelle on peut optionnellement remplacer jusqu'à 40 % en moles de titane par l'aluminium, la couche de revêtement (2) qui renferme du AlₓTi₁₋ₓN comportant au moins partiellement ou bien dans son intégralité des cristaux ayant une structure lamellaire.

16. Corps (1) revêtu selon la revendication 15, **caractérisé en ce que** la couche de revêtement en TiCN (3) présente en moyenne une composition TiCₐNi₁₋ₐ dans laquelle a est compris entre 0,3 et 0,8, notamment entre 0,4 et 0,6.

17. Corps (1) revêtu selon les revendications 15 ou 16, **caractérisé en ce que** la couche de revêtement (2) qui renferme du AlₓTi₁₋ₓN présente en moyenne une composition AlₓTi₁₋ₓN dans laquelle x ≥ 0,7 et dans laquelle la proportion d'AlN hexagonal est supérieure à 0 et inférieure ou égale à 30 % en moles.

18. Corps (1) revêtu selon la revendication 17, **caractérisé en ce que** la couche de revêtement (2) qui renferme du AlₓTi₁₋ₓN correspond à la couche de revêtement située le plus à l'extérieur.

19. Corps (1) revêtu selon l'une des revendications 15 à 18, **caractérisé en ce que** x ≥ 0,75, de préférence x ≥ 0,80, notamment x ≥ 0,85, et que la proportion d'AlN hexagonal est supérieure à 12,5 % en moles, de préférence supérieure à 15,0 % en moles, notamment supérieure à 20,0 % en moles, et qu'au sein de la couche de revêtement (2) qui renferme du AlₓTi₁₋ₓN, la proportion d'une phase de AlₓTi₁₋ₓN cubique est d'au moins 70 % en moles et préférentiellement comprise entre 70 et 80 % en moles.

20. Corps (1) revêtu selon la revendication 15 , **caractérisé en ce que** la structure lamellaire desdits cristaux comporte des lamelles dont l'épaisseur est inférieure à 100 nm, de préférence inférieure à 50 nm, notamment inférieure à 25 nm.
